Europäisches Patentamt

European Patent Office

Office européen des brevets

(11) Veröffentlichungsnummer: **0 015 226**
**B1**

(12) **EUROPÄISCHE PATENTSCHRIFT**

(45) Veröffentlichungstag der Patentschrift:
04.05.83

(51) Int. Cl.³: **G 01 R 31/08, H 02 H 1/00**

(21) Anmeldenummer: 80730009.0

(22) Anmeldetag: 06.02.80

(54) Schaltungsanordnung zum Speichern der Phasenlage einer Wechselspannung.

(30) Priorität: 27.02.79 DE 2907682

(43) Veröffentlichungstag der Anmeldung:
03.09.80 Patentblatt 80/18

(45) Bekanntmachung des Hinweises auf die Patenterteilung:
04.05.83 Patentblatt 83/18

(84) Benannte Vertragsstaaten:
CH FR GB SE

(56) Entgegenhaltungen:
CH-A-557 610
DE-A-2 430 780
DE-A-2 602 805
FR-A-2 093 262
US-A-3 965 432
IBM TECHNICAL DISCLOSURE BULLETIN, Band 14, November 1971, New York, US. E. K. WOO: »Variable frequency and pulse-width logic oscillator«, Seiten 1937—1938

(73) Patentinhaber: SIEMENS AKTIENGESELLSCHAFT,
Berlin und München Wittelsbacherplatz 2,
D-8000 München 2 (DE)

(72) Erfinder: Offermanns, Walter, Quellweg 13,
D-1000 Berlin 13 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Schaltungsanordnung zum Speichern der Phasenlage einer Wechselspannung

Die Erfindung bezieht sich auf Schaltungsanordnungen zum Speichern der Phasenlage einer Wechselspannung, wie sie unter anderem in Geräten zum Schutz elektrischer Energieübertragungsleitungen eingesetzt werden, wenn es beispielsweise darum geht, vom Einbauort des Gerätes aus gesehen die Richtung eines Kurzschlußortes zuverlässig zu bestimmen. Für diese Richtungsbestimmung werden zwei Meßgrößen benötigt, nämlich beispielsweise Strom und Spannung im Kurzschlußfalle am Einbauort des Gerätes, um aus deren Phasendifferenz auf die Richtung des Kurzschlusses schließen zu können. Die Richtungsbestimmung ist dann davon abhängig, daß auch im Kurzschlußfalle am Einbauort des Gerätes eine vom Werte Null abweichende Kurzschlußspannung vorhanden ist.

Diese Bedingung ist nicht immer erfüllt, so daß man bestrebt ist, in einem mehrphasigen Energieübertragungssystem Spannungen der Phasen zu benutzen, die nicht am Kurzschluß beteiligt sind. Da aber bei bestimmten Fehlerfällen auch derartige »kurzschlußfremde« Spannungen nicht vorhanden sind, werden Schaltungsanordnungen zum Speichern der Phasenlage der Kurzschlußspannung eingesetzt. Bekannte Schaltungsanordnungen dieser Art (Siemens-Katalog R2, 1978, »Konventionelle Schutzeinrichtungen und Relais«, Seite 5/45) bestehen aus Schwingkreisen, die auch bei völligem Zusammenbruch der Spannung am zu überwachenden Energieübertragungssystem während ihres Ausschwingens die Phasenlage der Spannung vor Eintritt des Kurzschlusses für eine zur Richtungsbestimmung ausreichend lange Zeit aufrechterhalten.

Schwierigkeiten bereitet der Einsatz von aus Schwingkreisen bestehenden Schaltungsanordnungen zum Speichern der Phasenlage einer Wechselspannung vor allem dann, wenn im Kurzschlußfalle mit einer Umkehr der Polarität der Spannung gerechnet werden muß. Dies gilt z. B. für Energieübertragungsleitungen mit Serienkondensatoren, wenn der Kurzschluß hinter einem Kondensator auftritt. In diesem Fall muß nämlich der Schwingkreis schnellstens von der Spannung abgekoppelt werden, damit diese ihn nicht in einen falschen Synchronismus zieht.

Diese Unzulänglichkeiten weist eine andere bekannte Spannungsgedächtnis-Schaltung (DE-A-2 430 720) nicht auf, die aus einem spannungsgesteuerten Oszillator und mindestens einem Regelkreis besteht. Der Regelkreis enthält einen Phasenkomparator mit einer Logik-Anordnung, in der den positiven Halbwellen der Wechselspannung entsprechende Impulse erzeugt werden.

Der Regelkreis weist ferner eine Steueranordnung in Form eines Sperrkreises auf, der mittels unter Berücksichtigung der Wechselspannung gewonnener Impulse gesteuert ist; der Sperrkreis ist mit der Logik-Anordnung verbunden. Bei einer Änderung der Phasenlage der Wechselspannung gibt der Sperrkreis Sperrsignale an den Phasenkomparator, woraufhin der spannungsgesteuerte Oszillator von einem erzwungenen in einen freien Schwingungszustand übergeht und damit eine Spannung erzeugt, die der Wechselspannung vor ihrer Änderung entspricht.

Eine derartige Spannungsgedächtnis-Schaltung hat den Nachteil, daß sie zum Einschwingen eine beträchtliche Zeit benötigt, während der der Oszillator zur Richtungsbestimmung nicht benutzt werden kann. Zur Vermeidung dieses Nachteils ist bei einer weiteren bekannten Spannungsgedächtnis-Schaltung (DE-A-2 602 805) ähnlichen Aufbaues im Regelkreis die Schaltstrecke einer elektronischen Schaltvorrichtung geschaltet und ein Blockierungssignaleingang des Oszillators mit einer Startschaltung zur Erzeugung von Startimpulsen verbunden, um mit jedem Startimpuls die Blockierung des Oszillators aufzuheben.

Die Erfindung geht aus von einer Schaltungsanordnung der im Oberbegriff des Anspruchs 1 genannten Art und stellt sich die Aufgabe, eine Schaltungsanordnung zum Speichern der Phasenlage einer Wechselspannung vorzuschlagen, die bei einem Verschwinden der Wechselspannung und auch bei einer sprunghaften Änderung ihrer Phasenlage mit vergleichsweise geringem Schaltungsaufwand sicherstellt, daß die ursprüngliche Phasenlage gespeichert ist.

Zur Lösung dieser Aufgabe sind bei der genannten Schaltungsanordnung die im Kennzeichen des Anspruchs 1 angegebenen Merkmale vorgesehen.

Die erfindungsgemäße Schaltungsanordnung arbeitet also in der Weise, daß — gesteuert durch die Steueranordnung — die monostabilen Kippstufen dem Einfluß der Wechselspannung entzogen werden, wenn die Wechselspannung ihre Phasenlage ändert, und dann gewissermaßen eigengesteuert für eine vorwählbare Zeitdauer an ihren Ausgängen weiterhin Rechteckimpulsfolgen erzeugen, die in ihrer Phasenlage mit den vor der Umschaltung auf Eigensteuerung erzeugten Rechteckimpulsfolgen übereinstimmen; dies ist dadurch erreicht, daß durch die Steueranordnung die den monostabilen Kippstufen vorgeordneten Logikschaltungen nur für die Rechteckimpulse durchlässig geschaltet werden, die vom Ausgang der jeweils einen monostabilen Kippstufe der jeweils anderen monostabilen Kippstufe eingangsseitig zugeführt werden. Die Eigensteuerung der Schaltungsanordnung, d. h. die von der Wechselspannung unbeeinflußte Erzeugung von Rechteckimpulsfolgen an den Ausgängen der monostabilen Kippstufen, kann beliebig lange erfolgen; im allgemeinen wird die Zeitdauer für die Eigensteuerung durch das jeweilige Meßproblem vorgegeben, im Falle einer Anwendung der erfindungsgemäßen Schaltungsanordnung in einem Gerät zum Schutz eines elektrischen Energieübertragungssystems im allgemeinen so lang gewählt, bis die Richtungsbestimmung des Kurzschlusses mit Sicherheit abgeschlossen ist.

Ein Vorteil der erfindungsgemäßen Schaltungsanordnung besteht darin, daß sie auch bei einem Verschwinden der Wechselspannung für jeweils ausreichend lange Zeit eine Speicherung deren Phasenlage ermöglicht. Ein weiterer Vorteil ist darin zu sehen, daß durch beliebige Änderungen der Phasenlage der Wechselspannung der Speichervorgang der Phasenlage nicht störend beeinflußt wird, also in jedem Fall sichergestellt ist, daß die gespeicherte Phasenlage der Phasenlage der Wechselspannung vor ihrer Änderung genau entspricht.

Ein weiterer Vorteil der erfindungsgemäßen Schaltungsanordnung besteht darin, daß aufgrund der Beaufschlagung der einen Logikschaltung mit den negativen Halbwellen der Wechselspannung entsprechenden Impulsen und der weiteren Logikschaltungen mit den positiven Halbwellen der Wechselspannung entsprechenden Impulsen bei einer sprunghaften Änderung der Phasenlage der Wechselspannung durch das Ende des letzten vor Änderung der Phasenlage erzeugten positiven oder negativen Impulses entweder am Ausgang der einen oder der weiteren monostabilen Kippstufe noch ein Impuls erzeugt wird, der sich exakt an die Rechteckimpulsfolge anschließt; zeitlich parallel dazu kann die Änderung der Phasenlage der Wechselspannung erfaßt und von der Steueranordnung die Anordnung mit den Logikschaltungen und den monostabilen Kippstufen auf Eigensteuerung umgeschaltet werden. Die Rechteckimpulsfolgen erscheinen daher an den Ausgängen der monostabilen Kippstufen in unveränderter Form und ohne Unterbrechung trotz der geänderten Phasenlage weiter.

Es können sowohl die Logikschaltungen als auch die Steueranordnung der erfindungsgemäßen Schaltungsanordnung unterschiedlich ausgebildet sein; die heute verfügbaren digitalen Schaltungsanordnungen bieten dafür vielfältige Ausführungsmöglichkeiten. Im Hinblick auf einen möglichst einfachen und überschaubaren sowie zuverlässigen Schaltungsaufbau erscheint es jedoch vorteilhaft, wenn jede Logikschaltung aus zwei UND-Gliedern und einem diesen nachgeordneten ODER-Glied besteht, wenn an dem einen Eingang des einen UND-Gliedes der einen Logikschaltung die den negativen Halbwellen der Wechselspannung entsprechenden Impulse und an dem einen Eingang des einen UND-Gliedes der weiteren Logikschaltung die den positiven Halbwellen der Wechselspannung entsprechenden Impulse liegen und wenn an dem anderen Eingang des jeweils einen UND-Gliedes ein Ausgang der Steueranordnung angeschlossen ist; der eine Eingang des jeweils anderen UND-Gliedes ist mit einem weiteren Ausgang der Steueranordnung und der andere Eingang des jeweils anderen UND-Gliedes mit dem Ausgang der jeweils nicht nachgeordneten monostabilen Kippstufe verbunden.

Um Änderungen der Phasenlage der Wechselspannung zu erfassen und die Steueranordnung entsprechend zu beeinflussen, ist es vorteilhaft, der Steueranordnung eine Überwachungsschaltung vorzuordnen, die bei einer Änderung der Phasenlage der an ihrem Eingang liegenden Wechselspannung ausgangsseitig ein Steuersignal an die Steueranordnung abgibt. Zur Erzeugung des Steuersignals kann die Überwachungsschaltung einen unterschiedlichen Aufbau aufweisen. Als vorteilhaft wird es jedoch angesehen, wenn die Überwachungsschaltung eine zusätzliche monostabile Kippstufe enthält, die an ihrem Ausgang den negativen Halbwellen der Wechselspannung entsprechende Impulse abgibt und eine weitere zusätzliche monostabile Kippstufe aufweist, die an ihrem Ausgang den positiven Halbwellen der Wechselspannung entsprechende weitere Impulse erzeugt; an die Ausgänge der beiden zusätzlichen monostabilen Kippstufen ist ein Koinzidenz-Glied angeschlossen, dessen Ausgang mit einem Eingang der Steueranordnung in Verbindung steht.

Die den beiden Logikschaltungen der erfindungsgemäßen Schaltungsanordnung zuzuführenden, den jeweiligen Halbwellen der Wechselspannung entsprechenden Impulse können mittels ergänzender monostabiler Kippstufen erzeugt werden, die eingangsseitig an der Wechselspannung liegen. Zur Schaltungsvereinfachung erscheint es jedoch vorteilhafter, wenn der Ausgang der einen zusätzlichen monostabilen Kippstufe mit dem einen Eingang des einen UND-Gliedes der einen Logikschaltung und der Ausgang der weiteren zusätzlichen monostabilen Kippstufe mit dem einen Eingang des einen UND-Gliedes der weiteren Logikschaltung verbunden ist. In diesem Falle werden keine ergänzenden monostabilen Kippstufen benötigt, weil die zusätzlichen monostabilen Kippstufen zur Erzeugung der den Halbwellen der Wechselspannung entsprechenden Impulse mit ausgenutzt werden.

Die Steueranordnung der erfindungsgemäßen Schaltungsanordnung kann unterschiedlich ausgeführt sein. Zur Erzielung einer Speicherwirkung für das von der Überwachungsschaltung bei einer Änderung der Phasenlage erzeugte Signal enthält sie jedoch vorteilhafterweise eine bistabile Kippstufe, deren beide Ausgänge mit den UND-Gliedern der Logikschaltungen verbunden sind.

Um sicherzustellen, daß nach Ablauf der für die Speicherung der Phasenlage der Wechselspannung vorgesehenen Zeitdauer die Logikschaltungen wieder von den Impulsen an den Ausgängen der monostabilen Kippstufen steuerbar sind, liegen die Ausgänge der beiden zusätzlichen monostabilen Kippstufen vorteilhafterweise über ein zusätzliches ODER-Glied an einem Eingang der bistabilen Kippstufe, so daß die bistabile Kippstufe wieder zurückgesetzt wird.

Da das am Ausgang des Koinzidenz-Gliedes anstehende Signal in seiner Länge von der Änderung der Phasenlage der Wechselspannung abhängig ist, die Speicherung der Phasenlage der Wechselspannung aber für eine aus meßtechnischen Gründen erforderliche Zeitdauer aufrechterhalten werden soll, ist es vorteilhaft, die Steueranordnung eingangsseitig mit einer zeitbestimmenden monostabilen Kippstufe zu versehen. Die Dauer des Ausgangsimpulses dieser monostabilen Kippstufe bestimmt wegen einer Verbindung des Ausgangs der zeitbestimmenden monostabilen Kippstufe mit den Rücksetzeingängen der beiden zusätzlichen monostabilen Kippstufen die Zeitdauer, während der die bistabile Kippstufe nicht zurückgestellt werden kann, d. h. die ursprüngliche Phasenlage der Wechselspannung gespeichert ist.

Um nicht auch vernachlässigbar kleine Änderungen der Phasenlage bzw. geringe Frequenzabweichungen der Wechselspannung durch die Überwachungsschaltung zu erfassen, wird es als vorteilhaft angesehen, wenn in Reihe mit dem Koinzidenz-Glied und der zeitbestimmenden Kippstufe eine Verzögerungsstufe angeordnet ist.

Zur Erläuterung der Erfindung ist in

Fig. 1 ein Blockschaltbild eines Ausführungsbeispiels der erfindungsgemäßen Schaltungsanordnung, in

Fig. 2 ein weitere Einzelheiten des Ausführungsbeispiels nach Fig. 1 wiedergegebenes Schaltbild und in

Fig. 3 die Wirkungsweise dieses Ausführungsbeispiels anhand von Diagrammen dargestellt.

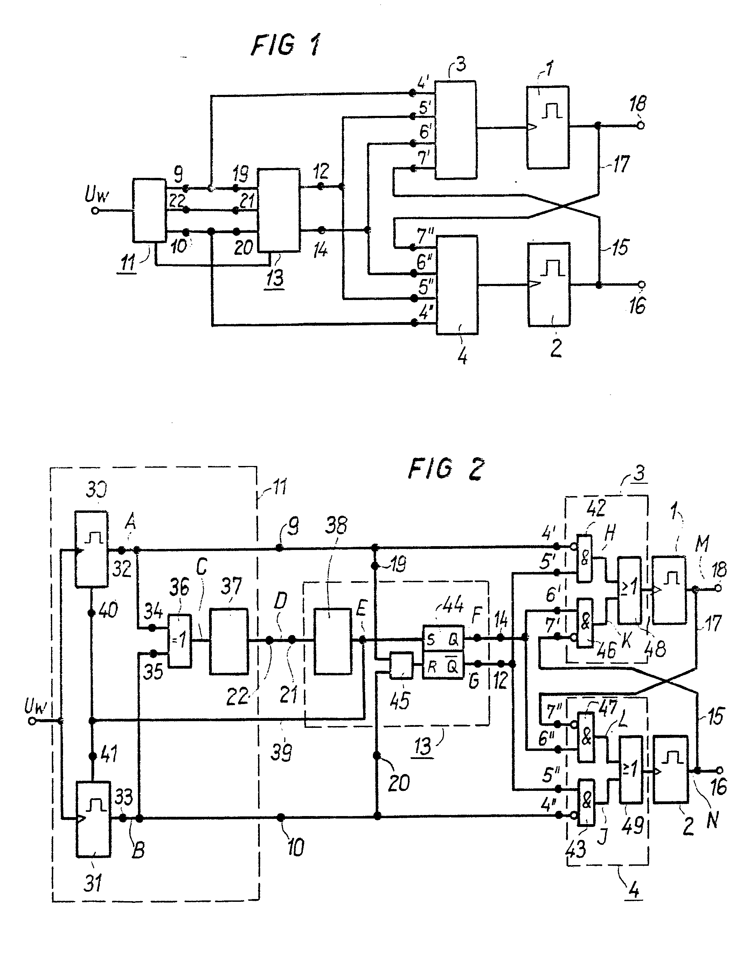

Wie Fig. 1 erkennen läßt, enthält die Schaltungsanordnung zum Speichern der Phasenlage einer Wechselspannung Uw eine monostabile Kippstufe 1 und eine weitere monostabile Kippstufe 2. Die Kippstufen 1 und 2 können z. B. so ausgebildet sein, wie es in dem Buch von Tietze/Schenk »Halbleiter-Schaltungstechnik«, 3. Aufl., 1976, Seiten 303 und 304 beschrieben ist. Der monostabilen Kippstufe 1 ist eine Logikschaltung 3 und der weiteren monostabilen Kippstufe 2 eine weitere Logikschaltung 4 vorgeordnet. Die Logikschaltung 3 weist Eingänge 4', 5', 6' und 7' auf; die Logikschaltung 4, die der Logikschaltung 3 entsprechend aufgebaut ist, besitzt entsprechende Eingänge 4'', 5'', 6'' und 7''. Die Eingänge 4' und 4'' sind an Ausgänge 9 und 10 einer Überwachungsschaltung 11 herangeführt. Die Eingänge 5' und 5'' sind mit einem Ausgang 12 einer Steueranordnung 13 verbunden, während die Eingänge 6' und 6'' der Logikschaltungen 3 und 4 mit einem weiteren Ausgang 14 der Steueranordnung 13 in Verbindung stehen. Der Eingang 7' der einen Logikschaltung 3 ist über eine Leitung 15 mit dem Ausgang 16 der weiteren monostabilen Kippstufe 2 verbunden, während der Eingang 7'' über eine Leitung 17 mit dem Ausgang 18 der einen monostabilen Kippstufe 1 in Verbindung steht.

Die Ausgänge der Logikschaltungen 3 und 4 sind unmittelbar mit den Eingängen der monostabilen Kippstufen 1 und 2 verbunden.

Die Steueranordnung 13 besitzt drei Eingänge 19, 20 und 21. Die Eingänge 19 und 20 sind wie die Eingänge 4' und 4'' der Logikschaltungen 3 und 4 mit den Ausgängen 9 und 10 der Überwachungsschaltung 11 verbunden. Der Eingang 21 der Steueranordnung 13 ist mit einem zusätzlichen Ausgang 22 der Überwachungsschaltung 11 verbunden und erhält darüber ein Signal, wenn sich die Phasenlage der Wechselspannung Uw ändert.

Die schaltungsmäßige Ausgestaltung des Ausführungsbeispiels nach Fig. 1 in Form der Schaltung nach Fig. 2 zeigt, daß die Überwachungsschaltung 11 eine zusätzliche monostabile Kippstufe 30 und eine weitere zusätzliche monostabile Kippstufe 31 enthält, die beide mit ihrem Eingängen an die Wechselspannung Uw angeschlossen sind. Die Ausgänge 32 und 33 der beiden zusätzlichen Kippstufen 30 und 31 sind an Eingänge 34 und 35 eines Koinzidenz-Gliedes 36 geführt. Dem Koinzidenz-Glied 36 — beispielsweise so ausgeführt, wie es aus dem Buch von Tietze/Schenk »Halbleiter-Schaltungstechnik«, 3. Aufl. 1976, Seiten 489 und 490 hervorgeht — ist eine Verzögerungsstufe 37 (beispielsweise gemäß »Siemens-Datenbuch 1976/77«, Seiten 468 bis 470 ausgeführt) nachgeordnet. Der Ausgang der Verzögerungsstufe 37 bildet den Ausgang 22 der Überwachungsschaltung 11.

Die Ausgänge 32 und 33 der zusätzlichen monostabilen Kippstufen 30 und 31 sind außerdem an die Ausgänge 9 und 10 der Überwachungsschaltung 11 geführt, so daß an dem Eingang 4' des einen UND-Gliedes 42 der Logikschaltung 3 sowie an einem Eingang 4'' des einen UND-Gliedes 43 der weiteren Logikschaltung 4 die Ausgangsgrößen der zusätzlichen monostabilen Kippstufen 30 und 31 anstehen.

In der Steueranordnung 13 ist eingangsseitig eine zeitbestimmende monostabile Kippstufe 38 vorgesehen. Der Ausgang der zeitbestimmenden monostabilen Kippstufe 38, die im Prinzip wie die Kippstufen 1 und 2 aufgebaut sein kann, ist über eine Verbindung 39 mit Rücksetzeingängen 40 und 41 der zusätzlichen monostabilen Kippstufen 30 und 31 verbunden. Als zusätzliche monostabile Kippstufen mit Rücksetzeingang können Kippstufen verwendet werden, deren Schaltungen mit denen der Kippstufen 1 und 2 übereinstimmen.

Der monostabilen Kippstufe 38 ist eine bistabile Kippstufe 44 nachgeordnet, die beispielsweise als RS-Flip-Flop ausgeführt sein kann (vgl. Tietze/Schenk »Halbleiter-Schaltungstechnik«, 3. Aufl., 1976, Seiten 465 bis 468). Das Flip-Flop ist dabei so angeordnet, daß sein Eingang S mit dem Ausgang der monostabilen Kippstufe 38 und sein Eingang R über ein ODER-Glied 45 mit den Eingängen 19 und 20 der Steueranordnung 13 verbunden ist. Der Ausgang Q des Flip-Flop ist mit dem Ausgang 14 der Steueranordnung 13 und der Ausgang $\overline{Q}$ ist mit

dem Ausgang 12 der Steueranordnung 13 verbunden.

Der Ausgang 12 bzw. $\bar{Q}$ ist mit den Eingängen 5' und 5'' der jeweils einen UND-Glieder 42 und 43 der Logikschaltungen 3 und 4 verbunden, während der Ausgang 14 bzw. Q mit den Eingängen 6' und 6'' des jeweils anderen UND-Gliedes 46 bzw. 47 der Logikschaltungen 3 und 4 in Verbindung steht. Der andere Eingang 7' bzw. 7'' des jeweils anderen UND-Gliedes 46 bzw. 47 ist über die Leitungen 17 und 15 mit den Ausgängen 16 und 18 der monostabilen Kippstufen 1 und 2 verbunden.

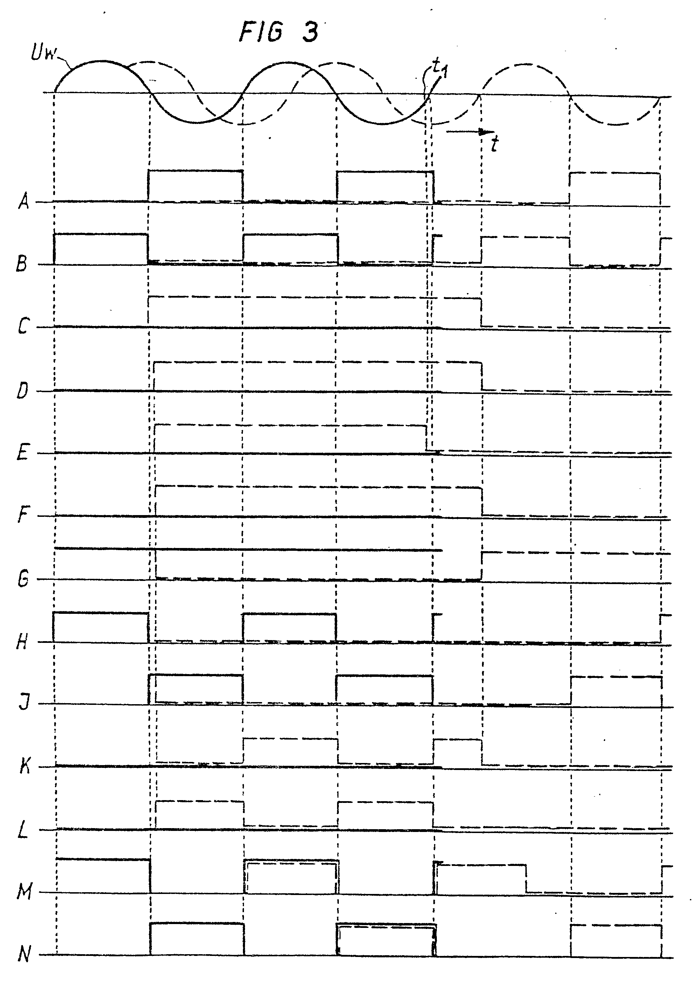

Zur Erläuterung der Wirkungsweise der erfindungsgemäßen Schaltungsanordnung nach Fig. 2 soll auf die Impulsdiagramme nach Fig. 3 zurückgegriffen werden. Die Impulsdiagramme sind durch große Buchstaben gekennzeichnet, mit denen in Fig. 2 die entsprechenden Stellen der Schaltung markiert sind, an denen diese Impulse auftreten.

Es ist zunächst angenommen, daß die Wechselspannung Uw die im oberen Diagramm angegebene Phasenlage aufweist. Dies führt dazu, daß an den Schaltungspunkten A und B infolge der zusätzlichen monostabilen Kippstufen 30 und 31 Impulse A und B entstehen, wie sie in den Diagrammen A und B der Fig. 3 ausgezogen wiedergegeben sind. Am Ausgang des Koinzidenz-Gliedes 36 tritt ein Impuls nicht auf; dies zeigt das Diagramm C. Entsprechend ergeben sich auch an den Schaltungspunkten D und E nach der Verzögerungsstufe 37 und der zeitbestimmenden monostabilen Kippstufe 38 keine Impulse. Es wird dann auch der S-Eingang der bistabilen Kippstufe 44 nicht mit einem Impuls beaufschlagt, so daß er sein Ausgangssignal beibehält (vgl. Diagramm F). Am Schaltungspunkt G hingegen, der den zu Q komplementären Ausgang $\bar{Q}$ darstellt, ergibt sich ein Signal (Diagramm G). Bei dieser Sachlage ergeben sich am Ausgang des einen UND-Gliedes 42 die am Diagramm H dargestellten Impulse und am Ausgang des einen UND-Gliedes 43 die im Diagramm J wiedergegebenen Impulse. An den Ausgängen der jeweils anderen UND-Glieder 46 und 47 der Logikschaltungen 3 und 4 hingegen treten keine Impulse auf, so daß sich wegen den UND-Gliedern 42 und 46 bzw. 43 und 47 nachgeordneten ODER-Gliedern 48 und 49 an den Ausgängen 16 und 18 der monostabilen Kippstufen 1 und 2 mit N und M gekennzeichnete Rechteckimpulsfolgen einstellen, wobei M exakt mit der Phasenlage der Spannung Uw übereinstimmt und N exakt in Gegenphase dazu ist.

Verändert die Spannung Uw sprungartig ihre Phasenlage und nimmt den in Fig. 3 strichliert eingezeichneten Verlauf ein, dann ergeben sich an den Ausgängen der zusätzlichen monostabilen Kippstufen 30 und 31 die in den Diagrammen A und B strichliert eingezeichneten Verhältnisse, und es wird am Ausgang des Koinzidenz-Gliedes der in Diagramm C strichliert eingezeichnete Impuls erzeugt. Dieser Impuls C wird über die Verzögerungsstufe 37 etwas zeitverzögert weitergegeben und in der zeitbestimmenden monostabilen Kippstufe 38 in ein Signal E umgeformt. Dieses Signal gelangt an den S-Eingang der bistabilen Kippstufe 44 und führt an deren Ausgang Q und damit am Ausgang 14 der Steueranordnung 13 zu einer Signaländerung (Diagramm F). Entsprechend ändert sich das Signal am Ausgang $\bar{Q}$ bzw. am Ausgang 12 der Steueranordnung 13 (Diagramm G). Dadurch werden die UND-Glieder 42 und 43 gesperrt, so daß ab diesem Zeitpunkt an ihren Ausgängen kein Signal mehr ansteht (siehe Diagramme H und J). Am Ausgang des anderen UND-Gliedes 46 hingegen entstehen nunmehr Rechteckimpulse in einer zeitlichen Folge, wie dies bei ungeänderter Phasenlage am Ausgang der UND-Glieder 42 und 43 der Fall war, weil nunmehr über die Verbindungen 15 und 17 die Rechteckimpulse vom Ausgang der monostabilen Kippstufen 1 und 2 gegenseitig zurückgeführt werden können und auf die Eingänge dieser monostabilen Kippstufen gelangen. Die strichliert eingezeichneten Impulse in den Diagrammen M und N zeigen, daß auch bei geänderter Phasenlage der Wechselspannung Uw Impulse entstehen, die in ihrer Phasenlage mit der Wechselspannung in ihrer ungeänderten Phasenlage übereinstimmen.

Mit dem Impuls E der zeitbestimmenden Kippstufe 38 werden auch die Rücksetzeingänge der zusätzlichen monostabilen Kippstufen 30 und 31 angesteuert und dadurch definierte Anfangsbedingungen für das Zurückschalten auf Steuerung der monostabilen Kippstufen 1 und 2 durch die Wechselspannung Uw geschaffen. Dies geschieht in der Weise, daß zum Zeitpunkt t1, d. h. nach Ablauf der zeitbestimmenden monostabilen Kippstufe 38, das Rücksetzsignal für die zusätzlichen monostabilen Kippstufen 30 und 31 aufgehoben wird, so daß diese durch die nach dem Zeitpunkt t1 auftretenden vollständigen Halbwellen der Wechselspannung Uw gesteuert werden und an ihren Ausgängen 32 und 33 die strichliert in den Diagrammen A und B gezeichneten Impulse abgeben. Mit dem ersten Impuls am Ausgang 33 wird die bistabile Kippstufe 44 zurückgesetzt, so daß ihr Ausgangssignal Q verschwindet (Diagramm F) und $\bar{Q}$ erscheint (Diagramm G). Dadurch werden die jeweils anderen UND-Glieder 46 und 47 gesperrt und die jeweils einen UND-Glieder 42 und 43 freigegeben, so daß die monostabilen Kippstufen 1 und 2 vom jeweils ersten Impuls der beiden zusätzlichen monostabilen Kippstufen 30 und 31 an von dieser gesteuert werden (Diagramme H bis N).

Mit der Erfindung ist eine Schaltungsanordnung zum Speichern der Phasenlage einer Wechselspannung vorgeschlagen, die beim Verschwinden der Wechselspannung und jeder beliebigen Änderung ihrer Phasenlage die ursprüngliche Phasenlage zu speichern gestattet.

**Patentansprüche**

1. Schaltungsanordnung zum Speichern der vor dem Verschwinden oder vor einer Phasenänderung einer Wechselspannung gegebenen Phasenlage dieser Wechselspannung, mit

— einer von der Wechselspannung (Uw) gesteuerten Steueranordnung (13) zur Erzeugung eines sich beim Verschwinden oder bei einer Phasenänderung der Wechselspannung ändernden Steuersignals (F, G),
— einem mit der Wechselspannung synchronisierbaren Signalgenerator (1, 2),
— einer von dem Steuersignal beaufschlagten und ausgangsseitig an den Signalgenerator angeschlossenen logischen Schaltungsanordnung (3, 4) durch die der Signalgenerator bei einer Änderung des Steuersignals aus einem mit der Wechselspannung synchronisierten Betriebszustand in einen freilaufenden Betriebszustand überführt wird, in dem Frequenz und Phasenlage des vorangehenden synchronisierten Zustands aufrecht erhalten werden,

dadurch gekennzeichnet, daß

a) der Signalgenerator folgende Einrichtungen enthält:
— eine monostabile Kippstufe (1),
— eine weitere monostabile Kippstufe (2),
b) die logische Schaltungsanordnung enthält:
— eine Logikschaltung (3), die ausgangsseitig an den Eingang der einen monostabilen Kippstufe (1) angeschlossen ist, die ferner eingangsseitig erstens mit dem Steuersignal, zweitens mit den negativen Halbwellen der Wechselspannung (Uw) entsprechenden Impulsen sowie drittens mit dem Ausgangssignal der weiteren monostabilen Kippstufe (2) beaufschlagt ist, und die so ausgebildet ist, daß sie unter dem Einfluß des Steuersignals vor dem Verschwinden oder einer Phasenänderung der Wechselspannung (Uw) die den negativen Halbwellen entsprechenden Impulse und nach dem Verschwinden oder einer Phasenänderung der Wechselspannung das Ausgangssignal der weiteren monostabilen Kippstufe (2) zum Eingang der einen monostabilen Kippstufe (1) durchläßt,
— eine weitere Logikschaltung (4), die ausgangsseitig an den Eingang der weiteren monostabilen Kippstufe (2) angeschlossen ist, die ferner eingangsseitig erstens mit dem Steuersignal, zweitens mit den positiven Halbwellen der Wechselspannung (Uw) entsprechenden Impulsen sowie drittens mit dem Ausgangssignal der einen monostabilen Kippstufe (1) beaufschlagt ist, und die so aufgebaut ist, daß sie unter dem Einfluß des Steuersignals vor dem Verschwinden oder einer Phasenänderung der Wechselspannung (Uw) die den positiven Halbwellen entsprechenden Impulse und nach dem Verschwinden oder einer Phasenänderung der Wechselspannung das Ausgangssignal der einen monostabilen Kippstufe (1) zum Eingang der weiteren monostabilen Kippstufe (2) durchläßt, und daß
c) der Schaltungsausgang (16, 18) von den Ausgängen der einen und der weiteren monostabilen Kippschaltung (1, 2) gebildet ist.

2. Schaltungsanordnung nach Anspruch 1, dadurch gekennzeichnet, daß jede Logikschaltung (3, 4) aus zwei UND-Gliedern (42, 46; 43, 47) und einem diesen nachgeordneten ODER-Glied (48; 49) besteht, daß an dem einen Eingang (4') des einen UND-Gliedes (42) der einen Logikschaltung (3) die den negativen Halbwellen der Wechselspannung (Uw) entsprechenden Impulse und an dem einen Eingang (4'') des einen UND-Gliedes (43) der weiteren Logikschaltung (4) die den positiven Halbwellen der Wechselspannung (Uw) entsprechenden Impulse liegen, daß an den anderen Eingang (5'; 5'') des jeweils einen UND-Gliedes (42; 43) ein Ausgang (12) der Steueranordnung (13) angeschlossen ist und daß der eine Eingang (6'; 6'') des jeweils anderen UND-Gliedes (46; 47) mit einem weiteren komplementären Ausgang (14) der Steueranordnung (13) und der andere Eingang (7'; 7'') des jeweils anderen UND-Gliedes (46; 47) mit dem Ausgang (16; 18) der jeweils nicht nachgeordneten monostabilen Kippstufe (2; 1) verbunden ist.

3. Schaltungsanordnung nach Anspruch 1 oder 2, dadurch gekennzeichnet, daß der Steueranordnung (13) eine Überwachungsschaltung (11) vorgeordnet ist, die bei einer Änderung der Phasenlage der an ihrem Eingang liegenden Wechselspannung (Uw) ausgangsseitig ein weiteres Steuersignal an die Steueranordnung (13) abgibt.

4. Schaltungsanordnung nach Anspruch 3, dadurch gekennzeichnet, daß die Überwachungsschaltung (11) eine zusätzliche monostabile Kippstufe (30) enthält, die an ihrem Ausgang (32) die den negativen Halbwellen der Wechselspannung (Uw) entsprechenden Impulse abgibt, und eine weitere zusätzliche monostabile Kippstufe (31) aufweist, die an ihrem Ausgang (33) die den positiven Halbwellen der Wechselspannung (Uw) entsprechenden Impulse erzeugt, und daß an die Ausgänge (32, 33) der beiden zusätzlichen monostabilen Kippstufen (30, 31) ein Koinzidenz-Glied (36) angeschlossen ist, dessen Ausgang mit einem Eingang (21) der Steueranordnung (13) in Verbindung steht.

5. Schaltungsanordnung nach Anspruch 4, dadurch gekennzeichnet, daß der Ausgang (32) der einen zusätzlichen monostabilen Kippstufe (30) mit dem einen Eingang (4') des einen UND-Gliedes (42) der eine Logikschaltung (3) und der Ausgang (33) der weiteren zusätzlichen monostabilen Kippstufe (31) mit dem einen Eingang (4″) des einen UND-Gliedes (43) der weiteren Logikschaltung (4) verbunden ist.

6. Schaltungsanordnung nach einem der vorangehenden Ansprüche, dadurch gekennzeichnet, daß die Steueranordnung (13) eine bistabile Kippstufe (44) enthält, deren beide Ausgänge (Q, Q̄) mit den UND-Gliedern (42, 46; 43, 47) der Logikschaltungen (3, 4) verbunden sind.

7. Schaltungsanordnung nach einem der vorangehenden Ansprüche, dadurch gekennzeichnet, daß die Steueranordnung (13) eingangsseitig eine zeitbestimmende monostabile Kippstufe (38) enthält.

8. Schaltungsanordnung nach Anspruch 6 oder 7, dadurch gekennzeichnet, daß die Ausgänge (32, 33) der beiden zusätzlichen monostabilen Kippstufen (30, 31) über ein zusätzliches ODER-Glied (45) mit einem Eingang (R) der bistabilen Kippstufe (44) verbunden sind.

## Claims

1. Circuit arrangement for storing the phase state of an alternating voltage which exists prior to the disappearance of or a phase change in said alternating voltage, comprising

- a control arrangement (13) which is controlled by the alternating voltage (Uw) and which serves to produce a control signal (F, G) which changes in the event of the disappearance of or a phase change in the alternating voltage
- a signal generator (1, 2) which can be synchronised with the alternating voltage,
- a logic circuit arrangement (3, 4) which is supplied with the control signal, whose output is connected to the signal generator, and which, in the event of a change in the control signal, converts the signal generator from an operating state synchronised to the alternating voltage to a free running operating state in which the frequency and phase state of the preceding synchronised state are maintained,

characterised in that

a) the signal generator contains the following devices:
    - a monostable flip-flop (1)
    - a further monostable flip-flop (2),
b) the logic circuit arrangement contains:
    - a logic circuit (3) whose output is connected to the input of the first monostable flip-flop (1), whose input is firstly supplied with the control signal, secondly with pulses corresponding to the negative half-waves of the alternating voltage (Uw) and thirdly with the output signal of the further monostable flip-flop (2), and which is designed in such manner that, under the influence of the control signal, prior to the disappearance of or a phase change in the alternating voltage (Uw) it allows through the pulses corresponding to the negative half-waves to the input of the firt monostable flip-flop (1), and following the disappearance of or a phase change in the alternating voltage allows through the output signal of the further monostable flip-flop (2),
    - a further logic circuit (4) whose output is connected to the input of the further monostable flip-flop (2), whose input is firstly supplied with the control signal, secondly with pulses corresponding to the positive half-waves of the alternating voltage (Uw) and thirdly with the output signal of the first monostable flip-flop (1), and which is constructed in such manner that, under the influence of the control signal, prior to the disappearance of or a phase change in the alternating voltage (Uw) it allows through the pulses corresponding to the positive half-waves to the input of the further monostable flip-flop (2), and following the disappearance of or a phase change in the alternating voltage it allows through the output signal of the first monostable flip-flop (1), and that
c) the circuit output (16, 18) is formed by the outputs of the first and the further monostable flip-flop circuits (1, 2).

2. Circuit arrangement as claimed in claim 1, characterised in that each logic circuit (3, 4) comprises two AND-Gates (42, 46; 43, 47) and a following OR-gate (48; 49), that the pulses which correspond to the negative half-waves of the alternating voltage (Uw) occur at the first input (4′) of the first AND-gate (42) of the first logic circuit (3), and the pulses which correspond to the positive half-waves of the alternating voltage (Uw) occur at the first input (4″) of the first AND-gate (43) of the further logic circuit (4), that an output (12) of the control arrangement (13) is connected to the other input (5′; 5″) of the first AND-gate (42; 43), and that the first input (6′; 6″) of the other AND-gate (46; 47) is connected to a further complementary output (14) of the control arrangement (13), and the other input (7′; 7″) of the other AND-gate (46; 47) is connected to the output (16; 18) of the monostable flip-flop (2; 1) which does not follow.

3. Circuit arrangement as claimed in claim 1 or 2, characterised in that the control arrangement (13) is preceded by a monotoring circuit (11) which, in the event of a change in the phase state of the alternating voltage (Uw) connected to its input, from its output emits a further control signal to the control arrangement (13).

4. Circuit arrangement as claimed in claim 3, characterised in that the monitoring circuit (11) contains an additional monostable flip-flop (30) which from its output (32) emits the pulses which correspond to the negative half-waves of the alternating voltage (Uw) and has a further additional monostable flip-flop (31) which at its output (33) produces the pulses which correspond to the positive half-waves of the alternating voltage (Uw), and that the outputs (32, 33) of the two additional monostable flip-flops (30, 31) are connected to a coincidence gate (36) whose output is connected to an input (21) of the control arrangement (13).

5. Circuit arrangement as claimed in claim 4, characterised in that the output (32) of the first additional monostable flip-flop (30) is connected to the first input (4') of the first AND-gate (42) of the first logic circuit (3), whereas the output (33) of the further additional monostable flip-flop (31) is connected to the first input (4'') of the first AND-gate (43) of the further logic circuit (4).

6. Circuit arrangement as claimed in one of the preceding claims, characterised in that the control arrangement (13) contains a bistable flip-flop (44) both outputs of which (Q, $\overline{Q}$) are connected to the AND-gates (42, 46; 43, 47) of the logic circuits (3; 4).

7. Circuit arrangement as claimed in one of the preceding claims, characterised in that at its input end the control arrangement (13) contains a time determining monostable flip-flop (38).

8. Circuit arrangement as claimed in claim 6 or 7, characterised in that the outputs (32, 33) of the two additional monostable flip-flops (30, 31) are connected via an additional OR-gate (45) to an input (R) of the bistable flip-flop (44).

## Revendications

1. Circuit pour mémoriser la position de phase d'une tension alternative avant la disparition ou avant une variation de phase de cette tension alternative, circuit comportant

— un dispositif de commande (13) qui est commandé par la tension alternative (Uw) pour produire un signal de commande (F, G) qui varie lors de la disparation ou lors d'une variation de phase de la tension alternative,

— un générateur de signaux (1, 2) pouvant être synchronisé avec la tension alternative,

— un montage logique (3, 4), qui reçoit le signal de commande et dont la sortie est reliée au générateur de signaux, et par l'intermédiaire duquel, lors d'une variation du signal de commande, le générateur de signaux passe d'un état de fonctionnement synchronisé avec tension alternative à un état de fonctionnement libre, dans lequel la fréquence et la position de phase de l'état synchronisé antérieur sont maintenues,

caractérisé par le fait que,

a) le générateur de signaux comprend les dispositifs suivants:
  — une bascule monostable (1),
  — une autre bascule monostable (2),

b) le montage logique comprend:
  — un circuit logique (3) qui est relié, côté sortie, à l'entrée de la première bascule monostable (1), qui reçoit en outre, côté entrée, premièrement le signal de commande, deuxièmement des impulsions correspondent aux alternances négatives de la tension alternative (Uw) ainsi que troisièmement le signal de sortie de l'autre bascule monostable (2), et qui est agencé de manière à transmettre à l'éntrée de la première bascule monostable, sous l'influence du signal de commande, les impulsions correspondant aux alternances négatives avant la disparition au une variation de phase de la tension alternative (Uw), et le signal de sortie de l'autre bascule monostable (2) après la disparition ou une variation de phase de la tension alternative,
  — un autre circuit logique (4) qui est relié, côté sortie, à l'entrée de l'autre bascule monostable (2), qui reçoit en outre, côté entrée, premièrement le signal de commande, deuxièmement des impulsions correspondant aux alternances positives de la tension alternatives (Uw), ainsi que troisièmement le signal de sortie de la première bascule monostable, et qui est agencée de manière à transmettre à l'entrée de l'autre bscule monostable (2), sous l'influence du signal de commande, les impulsions correspondant aux alternances positives avant la disparition ou une variation de phase de la tension alternative (Uw) et le signal de sortie de la première bascule monostable (1) après la disparition ou une variation de phase de la tension alternative, et que

c) la sortie du circuit (16, 18) est formée par les sorties de la première et de l'autre bascule bistable (1, 2).

2. Circuit suivant la revendication 1, caractérisé par le fait que chaque circuit logique (3, 4) est constitué par deux circuits ET (42, 46; 43, 47) et un circuit OU (48; 49) monté en aval de ceux-ci, que sur une des entrées (4') d'un des circuits ET (42) d'un des circuits logiques (3) sont appliquées les impulsions correspondant aux alternances négatives de la tension alternative (Uw), et sur une des entrées (4'') d'un des circuits ET (43) de l'autre circuit logique (4) sont appliquées les impulsions correspondant aux alternances positives de la tension alternative (Uw), qu'à l'autre entrée (5', 5'') du premier circuit ET respectif (42; 43) est raccordée la sortie (12) du dispositif de commande (13), et qu'une des entrées (6', 6'') de l'autre circuit ET respectif (46; 47) est reliée à une autre sortie complémentaire (14) du dispositif de commande (13) et l'autre entrée (7'; 7'') de l'autre circuit ET respectif (46; 47) est reliée à la sortie (16; 18) de la bascule monostable (2; 1) qui n'est respectivement pas montée en aval.

3. Circuit suivant la revendication 1 ou 2, caractérisé par le fait qu'en amont du dispositif de commende (13) est monté un circuit de surveillance (11) qui délivre à sa sortie un autre signal de commande pour le dispositif de commande (13), lors d'une variation de la position de phase de la tension alternative (Uw) appliquée à son entrée.

4. Circuit suivant la revendication 3, caractérisé par le fait que le circuit de surveillance (11) comporte une bascule monostable supplémentaire (30) qui délivre sur sa sortie (32) les impulsions correspondant aux alternances négatives de la tension alternative (Uw), et une autre bascule monostable supplémentaire (31) qui fournit sur sa sortie (33) les impulsions corrspondant aux alternances positives de la tension alternative (Qw), et qu'aux sorties (32, 33) des deux bascules monostables supplémentaires (30, 31) est raccordé un circuit de coïncidence (36) dont la sortie est réliée à une entrée (21) du dispositif de commande (13).

5. Circuit suivant la revendication 4, caractérisé par le fait que la sortie (32) d'une des bascules monostables supplémentaires (30) est reliée à une des entrées (4') d'un des circuits ET (42) d'un des circuits logiques (3), et la sortie (33) de l'autre bascule monostable supplémentaire (31) est reliée à une des entrées (4'') d'un des circuits ET (43) de l'autre circuit logique (4).

6. Circuit suivant l'une des revendications précédentes, caractérisé par le fait que le dispositif de commande (13) comprend une bascule bistable (44) dont les sorties (Q, $\overline{Q}$) sont reliées aux circuits ET (42, 46; 43, 47) des circuits logiques (3; 4).

7. Circuit suivant l'une des revendications précédentes, caractérisé par le fait que le dispositif de commande (13) comprend, côté entrée, une bascule monostable (38) de détermination du temps.

8. Circuit suivant l'une des revendications 6 ou 7, caractérisé par le fait que les sorties (32, 33) des deux bascules monostables supplémentaires (30, 31) sont reliées, par l'intermédiaire d'un circuit OU supplémentaire (45), à une entrée (R) de la bascule bistable (44).

# FIG 1

# FIG 2

# FIG 3